# FASCICULE DE BREVET EUROPEEN

(11) **EP 1 927 023 B1**
(45) Date de publication et mention de la délivrance du brevet: **24.08.2016**
(21) Numéro de dépôt: 06777504.9
(22) Date de dépôt: 29.06.2006
(51) Int. Cl.: G02B 6/08, G02B 6/42

(54) **CAPTEUR D'IMAGE RADIOLOGIQUE INTRAORAL DENTAIRE A GALETTE DE FIBRES OPTIQUES**
ZAHNMEDIZINISCHER INTRAORALER RADIOLOGISCHER BILDSENSOR MIT OPTISCHER FASERKONTAKTSTELLE
DENTAL INTRAORAL RADIOLOGICAL IMAGE SENSOR WITH OPTICAL FIBER PAD

(30) Priorité: 01.07.2005 FR 0507034
(43) Date de publication de la demande: 04.06.2008
(73) Titulaire: E2V Semiconductors, 38120 Saint Egrève (FR)
(72) Inventeur: FRITSCH, Lionel, F-38960 Saint Etienne De Crossey (FR); CAMBOU, Pierre, F-38000 Grenoble (FR)
(74) Mandataire: Bréda, Jean-Marc
(86) Numéro de dépôt international: PCT/EP2006/063675
(87) Numéro de publication internationale: WO 2007/003571

(56) Documents cités:
- EP-A- 1 300 692
- EP-A- 1 427 020
- FR-A- 2 815 140
- US-A- 4 900 930
- US-A- 6 042 267
- US-A1- 2003 031 435
- US-A1- 2003 164 453
- PATENT ABSTRACTS OF JAPAN vol. 017, no. 353 (E-1393), 5 juillet 1993 (1993-07-05) & JP 05 054840 A (HAMAMATSU PHOTONICS KK), 5 mars 1993 (1993-03-05)

## Description

L'invention concerne les capteurs d'image radiologique dentaire de faible encombrement et de haute résolution ; elle s'applique notamment, mais non exclusivement, aux capteurs d'image radiologique intraoraux.

Les capteurs d'image dentaire intaoraux existants (voir par exemple US 6 042 267) ne sont pas toujours optimisés du point de vue de l'encombrement, du fait qu'il faut trouver des compromis entre le coût de fabrication et les performances optiques désirées, et que ces compromis peuvent se faire au détriment d'autres paramètres comme l'encombrement, que ce soit en longueur, en largeur, ou en épaisseur. Or, l'encombrement est un paramètre essentiel puisque le capteur d'image doit être introduit dans la bouche d'un patient. Chaque millimètre ou fraction de millimètre gagné, dans chacune des trois dimensions, à surface de prise d'image donnée, représente un progrès significatif.

Les capteurs d'image radiologique existants sont habituellement réalisés de la manière suivante : on fabrique collectivement une série de puces détectrices d'image visible, individuelles, sur une tranche de silicium, par des opérations de dépôts et gravures de couches isolantes, conductrices ou semiconductrices, et des opérations de dopages, etc., toutes ces opérations étant effectuées à partir d'une face avant de la tranche. Après fabrication collective sur la tranche, la tranche est découpée en puces individuelles et les puces sont montées chacune sur un support ; des plages conductrices de la puce sont reliées à des plages conductrices du support par des fils soudés (technique dite "wire-bonding"). Puis, dans le cas de la radiologie, un scintillateur est déposé (en général collé) sur la face avant de la puce de silicium. Le scintillateur est destiné à convertir les rayons X incidents en rayonnement visible à une longueur d'onde à laquelle le capteur d'image est sensible.

On a déjà proposé d'interposer entre le scintillateur et la puce de silicium une galette plate de fibres optiques de quelques centaines de micromètres d'épaisseur, dont le but est d'atténuer (par simple absorption) le rayonnement X résiduel qui a traversé le scintillateur sans être converti en lumière visible ; en effet, les rayons X résiduels tendent à générer dans le silicium des électrons parasites qui représentent plus du bruit que du signal utile et il est souhaitable de les éliminer. La galette de fibres atténue les rayons X mais elle n'atténue pas la lumière visible qui a été émise par le scintillateur ; la résolution de l'image visible générée dans le scintillateur est conservée par la galette de fibres optiques et est répercutée sur la surface sensible du capteur ; c'est là son grand intérêt.

Dans ce cas, on colle sur la puce de silicium non pas une simple feuille de scintillateur mais une galette de fibres optiques revêtue d'une couche scintillatrice. La couche scintillatrice peut être une couche d'iodure de césium déposée sur la galette, ou bien, plus souvent, c'est une feuille de carbone revêtue d'iodure de césium qui est collée sur la galette par une colle transparente interposée entre l'iodure de césium et la galette. D'autres matériaux que l'iodure de césium peuvent être utilisés (feuilles de matière plastique chargée d'oxysulfure de gadolinium, etc.).

Les dispositifs fabriqués jusqu'à maintenant n'optimisent pas les dimensions du capteur d'image.

L'invention propose d'utiliser une galette de fibres optiques d'une manière nouvelle qui permet de faciliter la fabrication et d'améliorer les performances des capteurs, notamment en ce qui concerne l'encombrement, en épaisseur comme en dimensions latérales. Cette galette de fibres optiques est utilisable dans le cas d'un capteur d'image radiologique associée à un scintillateur.

Selon l'invention, on propose un procédé de fabrication consistant à réaliser collectivement une structure associant une tranche semiconductrice portant un réseau matriciel de détecteurs photosensibles intégrés dans la tranche, et une galette de fibres optiques fixée par adhérence moléculaire sans apport de matière adhésive à une face de la tranche, la tranche semiconductrice étant amincie dans une étape postérieure à la formation des circuits de détection d'image sur la tranche, et on réalise, sur la face de la tranche non fixée à la galette de fibres, des plots de contact d'accès extérieur pour la commande des circuits et le recueil de signaux d'image issus du capteur, la galette de fibres optiques ayant une épaisseur telle qu'elle assure l'essentiel de la tenue mécanique de la structure une fois que la tranche a été amincie, et ceci jusqu'à la fin de la fabrication collective, la structure assemblée de la tranche et de la galette étant ultérieurement découpée en puces individuelles.

Le découpage en puces se fait en principe par sciage et l'opération de sciage coupe simultanément la tranche amincie et la galette de fibres selon une même ligne de découpe. On profite ainsi de la protection contre les rayons X résiduels conférée par la galette de fibres optiques.

La galette de fibres est fixée à la tranche par adhérence moléculaire, sans apport de matière adhésive, entre deux surfaces très planes. Les surfaces très planes sont obtenues lorsque c'est nécessaire par dépôt d'une couche de planarisation noyant le relief puis polissage chimique et/ou mécanique jusqu'à obtenir une rugosité très faible (égale ou inférieure au nanomètre si possible).

Ainsi, selon l'invention, on se sert d'une galette de fibres optiques comme support d'une tranche semiconductrice amincie qui ne pourrait pas s'auto-supporter après amincissement. Le scintillateur est de préférence collé sur la galette alors que le processus de fabrication collective se déroule encore, c'est-à-dire avant division en puces individuelles. La galette joue son rôle de protection contre les rayons X mais elle a été mise en place lors des étapes collectives. La tranche de silicium peut être amincie fortement, d'une part pour diminuer l'épaisseur globale de la puce, afin de rendre possible la réalisation des plots de contacts sur la face accessible lorsque des vias doivent être réalisés entre les deux faces de la tranche, et d'autre part éventuellement pour améliorer les performances optiques du capteur. Les plots de contact de la puce sont situés sur une face de la tranche semiconductrice qui est la face opposée à la face collée contre la galette de fibres, ce qui évite des opérations de découpage complexe pour laisser libre l'accès aux plots ; un découpage complexe serait en effet nécessaire si les plots d'accès étaient situés du côté de la face collée, à la périphérie de la galette. On verra plus loin comment l'invention réduit l'encombrement latéral final du capteur. Enfin, le collage par adhérence moléculaire, possible entre des surfaces très planes en regard, permet d'éviter d'interposer entre la galette et la puce une colle transparente, dont l'épaisseur, les bulles et les défauts engendreraient une perte de qualité du capteur.

L'invention porte aussi sur un capteur d'image nouveau, de faible encombrement, comportant une puce formée d'une superposition d'une galette de fibres optiques et d'une feuille semiconductrice fixée à la feuille par adhérence moléculaire sans apport de matière adhésive, d'épaisseur plus faible que l'épaisseur de la galette et inférieure à 30 micromètres, feuille dans laquelle sont formés une matrice de zones photosensibles et des circuits électroniques associés, la feuille comportant, sur sa face non fixée à la galette de fibres, des plots de contact d'accès extérieur permettant la commande du capteur et le recueil de signaux d'image issus de la matrice.

Entre la feuille semiconductrice et la galette il y a seulement des couches de planarisation.

On a utilisé dans le paragraphe précédent le mot "feuille semiconductrice" par opposition au mot "puce semiconductrice" généralement utilisé, pour évoquer le fait qu'on n'a plus une puce rigide comme dans l'art antérieur mais plutôt une feuille extrêmement mince et non rigide, l'essentiel de la tenue mécanique étant assuré par la galette de fibres optiques. L'épaisseur de la feuille est de 30 micromètres au plus et elle peut même faire beaucoup moins (quelques micromètres seulement) ; l'épaisseur de la galette de fibres est en principe de quelques centaines de micromètres, le critère étant qu'elle puisse assurer la tenue mécanique pendant la fabrication collective. Exceptionnellement l'épaisseur de la galette peut descendre à environ 100 micromètres.

Comme on le verra, une particularité du capteur selon l'invention est que le bord périphérique de la galette surplombe exactement le bord périphérique de la feuille semiconductrice dans laquelle est formé le capteur d'image. De plus, lorsque la structure de la feuille et de la galette est montée sur un support (embase de boîtier, ou circuit hybride sur céramique, ou circuit imprimé) le support n'a pas besoin d'être en débord latéral par rapport à la structure.

Le procédé selon l'invention comporte deux modes principaux de mise en oeuvre selon qu'on fixe la galette sur la face avant ou sur la face arrière de la tranche semiconductrice. La face avant de la tranche est la face à partir de laquelle ont été formés les circuits électroniques des puces (matrices photosensibles et circuits associés).

Dans le premier mode de mise en oeuvre, c'est la face avant qui est collée contre la galette, et les plots de contact sont donc sur la face arrière de la tranche amincie ; des vias conducteurs traversent l'épaisseur de la tranche amincie pour relier les plots aux circuits électroniques. Le procédé de fabrication d'un capteur d'image de faible encombrement comporte alors les étapes suivantes : on part d'une tranche semiconductrice destinée à la réalisation simultanée de plusieurs capteurs individuels, on réalise à partir d'une face avant de la tranche, par des étapes de dépôt et gravures de couches successives, un ensemble de matrices de zones photosensibles et de circuits électroniques associés, on planarise la face avant, on planarise également une face avant d'une galette de fibres optiques d'épaisseur suffisante pour assurer la tenue mécanique de la tranche pendant le reste de la fabrication de celle-ci avant découpage en puces individuelles, on colle la galette par sa face avant planarisée contre la face avant planarisée de la tranche, le collage étant effectué par adhérence moléculaire sans interposition de matière adhésive, on élimine la majeure partie de l'épaisseur de la tranche semiconductrice par usinage de la face arrière de celle-ci, on établit sur la face arrière de la tranche amincie des plots de contact extérieur permettant la commande du capteur et le recueil de signaux d'image, ces plots étant reliés électriquement, à travers l'épaisseur de la tranche amincie, aux circuits réalisés sur la face avant de la tranche, et, ultérieurement, on découpe la tranche en puces individuelles.

Dans le deuxième mode de mise en oeuvre, c'est la face arrière qui est collée sur la galette. Pour cela, on utilise un substrat de report provisoire, de préférence en silicium, on colle la face avant de la tranche semiconductrice sur le substrat provisoire, on amincit la tranche par sa face arrière, le substrat provisoire assurant sa tenue mécanique pendant cette opération, on colle l'ensemble ainsi formé, par la face arrière de la tranche, contre une galette de fibres optiques, et on élimine le substrat provisoire, la galette devenant un substrat définitif qui assure la tenue mécanique de la tranche amincie. Les plots de contact sont alors situés sur la face avant de la tranche, maintenant accessible après enlèvement du substrat provisoire. Dans ce deuxième mode, le procédé de fabrication d'un capteur d'image de faible encombrement comporte alors les étapes suivantes : on part d'une tranche semiconductrice destinée à la réalisation simultanée de plusieurs capteurs individuels, on réalise à partir d'une face avant de la tranche, par des étapes de dépôt et gravures de couches successives, un ensemble de matrices de zones photosensibles et de circuits électroniques associés, et des plots de contact d'accès extérieur permettant la commande du capteur et le recueil de signaux d'image, on colle la face avant de la tranche contre la face avant d'un substrat de report provisoire, on élimine la majeure partie de l'épaisseur de la tranche par usinage de la face arrière de celle-ci, on planarise la face arrière de la tranche amincie, on planarise une face avant d'une galette de fibres optiques d'épaisseur suffisante pour assurer la tenue mécanique de la tranche pendant le reste de la fabrication de celle-ci avant découpage en capteurs d'image individuels, on colle la galette par sa face avant planarisée contre la face arrière planarisée de la tranche, le collage étant effectué par adhérence moléculaire sans apport de matière adhésive, on élimine le substrat de report provisoire, on dénude les plots de contact d'accès extérieur, et, ultérieurement, on découpe la tranche en puces individuelles.

D'autres caractéristiques et avantages de l'invention apparaîtront à la lecture de la decription détaillée qui suit et qui est faite en référence aux dessins annexés dans lesquels :
- la figure 1 représente une tranche semiconductrice sur la face avant de laquelle on a formé des circuits de détection d'image ;
- la figure 2 représente la tranche après une opération de planarisation ;
- la figure 3 représente une galette de fibres optiques ayant sa face avant planarisée ;
- la figure 4 représente une structure associant la tranche et la galette de fibres, collées face contre face ;
- la figure 5 représente une étape d'amincissement de la tranche ;
- la figure 6 représente la formation de vias conducteurs ;
- la figure 7 représente le dépôt et la gravure d'une couche conductrice sur la face arrière de la tranche amincie ;
- la figure 8 représente le dépôt d'un scintillateur sur la face accessible de la galette de fibres optiques ;
- la figure 9 représente un capteur d'image radiologique terminé, comprenant la structure tranche+galette découpée en une puce individuelle montée sur un support auquel elle est reliée par des fils soudés ;
- la figure 10 représente les marges d'encombrement latérales supplémentaires qu'il fallait prendre dans l'art antérieur pour monter une puce sur un support ;
- les figures 11 à 16 représentent les étapes de fabrication dans un deuxième mode de réalisation de l'invention ;
- la figure 17 représente un capteur d'image terminé dans ce deuxième mode.

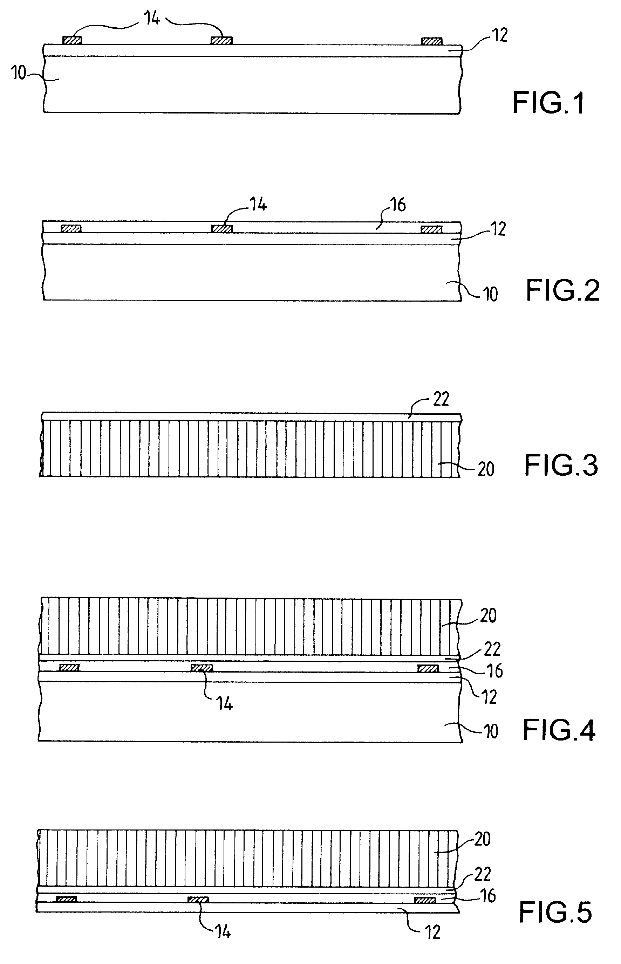

Sur la figure 1, on a représenté schématiquement une tranche semiconductrice 10 ; la tranche est classiquement un substrat semiconducteur dont la face avant porte une couche épitaxiale 12 peu dopée dans laquelle sont formés des circuits de détection d'image visible non représentés, destinés à être ultérieurement découpés en puces individuelles correspondant chacune à un capteur d'image individuel. Chaque circuit de détection d'image comprend une matrice photosensible, des circuits électroniques associés, des interconnexions, et des plages ou zones conductrices 14 destinées à être reliées à des connexions extérieures du capteur. Les connexions extérieures sont prévues pour l'alimentation et la commande des circuits électroniques du capteur ainsi que pour le recueil des signaux électroniques représentant les images détectées par le capteur.

La face avant de la tranche (en haut sur la figure 1) est la face à partir de laquelle sont faites les opérations classiques de dépôts de couches conductrices ou semiconductrices ou isolantes, gravures de ces couches, implantations, etc. permettant de réaliser collectivement les matrices, les circuits associés, et les plages conductrices (ces dernières en général en aluminium).

On va décrire d'abord, en référence aux figures 2 à 9, une première variante de réalisation de l'invention, dans laquelle la tranche semiconductrice est d'abord reportée sur une galette de fibres optiques avant de procéder à un amincissement de la tranche.

Pour cela, on commence (figure 2) par planariser la face avant de la tranche 10. En pratique, comme la surface avant de la tranche est modelée par le relief laissé par les dépôts et gravures successifs de couches, la planarisation consiste à recouvrir la face avant d'une couche de planarisation 16 (oxyde de silicium) de quelques micromètres d'épaisseur. Cette couche masque le relief présent sur la tranche, après quoi la surface de la tranche est polie (polissage mécanique et/ou chimique) pour acquérir une planéité aussi parfaite que possible en vue d'un collage par adhérence moléculaire (collage sans apport de matière adhésive entre deux surfaces très planes). La rugosité subsistante ne doit pas excéder, si possible, 1 nanomètre.

Une galette de fibres optiques 20 est préparée (figure 3) ; si sa surface n'est pas parfaitement plane, elle peut être aussi planarisée comme celle de la tranche, par dépôt d'une couche de planarisation 22 et polissage.

La galette de fibres est alors reportée (figure 4) sur la face avant de la tranche, par adhérence moléculaire. La ou les couches de planarisation, si elles sont prévues pour atteindre la planéité désirée, servent aussi de barrière contre les alcalins présents dans le verre de la galette de fibres.

La tranche semiconductrice est ensuite très fortement amincie (figure 5) ; l'amincissement ne laisse subsister que quelques dizaines de micromètres d'épaisseur (30 micromètres au maximum), et en pratique on peut même ne laisser que quelques micromètres d'épaisseur. L'amincissement se fait par usinage mécanique complété par un polissage mécanique et/ou chimique. La tranche semiconductrice amincie sera à partir de là désignée par la référence 12 puisqu'elle ne comprend plus, en pratique, que la couche épitaxiale 12, et même une fraction seulement de la couche épitaxiale originale. Toutefois, on peut aussi préférer garder une petite épaisseur du substrat d'origine 10.

Pour toute la suite des étapes collectives de fabrication, c'est-à-dire jusqu'à division de la tranche en capteurs individuels, c'est la galette de fibres optiques qui assure la tenue mécanique de la structure, la tranche semiconductrice ne pouvant plus assurer cette tenue compte-tenu de sa très faible épaisseur. La galette a une épaisseur de 200 à 1000 micromètres ou plus ; dans certains cas, l'épaisseur peut cependant être réduite à 100 micromètres, mais l'épaisseur de la tranche semiconductrice amincie est de toutes façons beaucoup plus faible que celle de la galette.

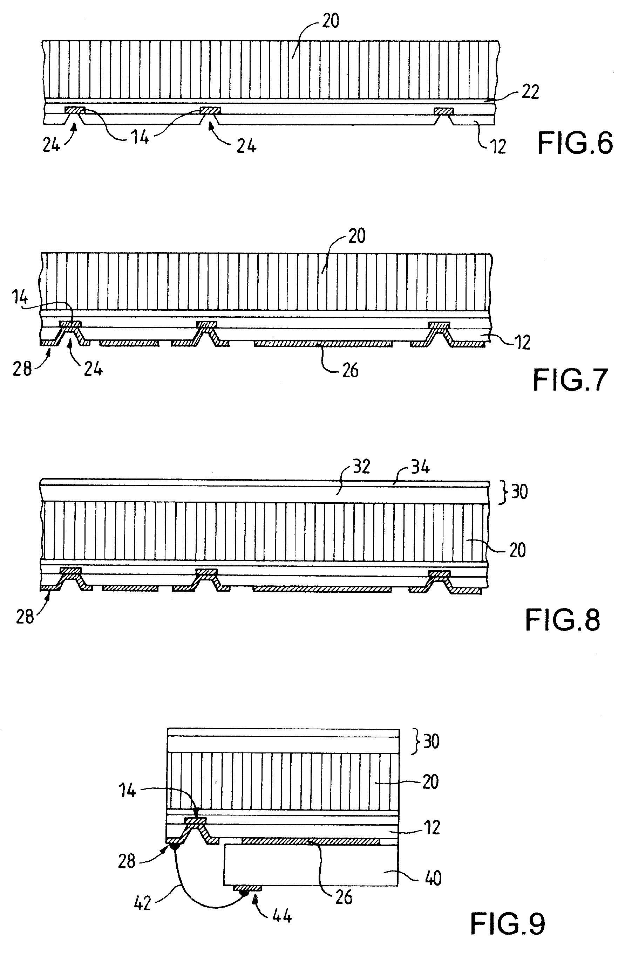

On réalise ensuite (figure 6), à partir de la face arrière de la tranche, des vias d'accès 24 à travers toute l'épaisseur de la tranche amincie 12 ; ces vias ouvrent un accès vers les plages conductrices 14 ou vers certaines d'entre elles.

Pour l'essentiel, ces vias sont formés par gravure chimique ou gravure ionique du silicium de la tranche 12, jusqu'à mise à nu des plages 14. Les vias servent à établir des passages pour relier électriquement les plages métalliques de la face avant à des conducteurs qui vont maintenant être formés sur la face arrière. Les vias ont été représentés comme des tranchées à flancs inclinés avec de l'aluminium déposé sur ces flancs ; cependant, si la tranche amincie ne fait que quelques micromètres d'épaisseur, les vias peuvent être constitués par des tranchées étroites à flancs verticaux, gravées par attaque plasma, qui se comblent d'aluminium lors du dépôt de la couche d'aluminium.

On dépose alors une couche isolante (non représentée) sur la face arrière de la tranche, puis on réouvre la couche isolante dans le fond des vias (mais pas sur les flancs), par gravure chimique ou ionique. Cette étape de dépôt et gravure d'isolant évite des court-circuits ultérieurs entre vias par la couche semiconductrice 12. Elle n'est pas obligatoire si le mode d'ouverture des vias fait qu'il n'y a pas de risques de ce point de vue.On dépose alors une couche conductrice 26 (en pratique de l'aluminium) sur la face arrière de la tranche ; elle vient en contact avec les plots 14 à l'intérieur des vias 24.

On grave (figure 7) par photolithographie dans la couche d'aluminium 26 un motif d'interconnexion laissant subsister l'aluminium dans les vias 24 et laissant subsister des plots de contact d'accès ou plots de soudure 28, destinés à la soudure ultérieure de fils de connexion. Les plots 28 à l'extérieur des vias ne sont pas nécessaires dans le cas où les fils peuvent être soudés directement au fond des vias : le fond des vias sert alors de plot de contact. La couche d'aluminium peut être protégée, aux endroits qui n'ont pas besoin d'être accessibles pour une soudure, par une couche de passivation non représentée. Au lieu de fils soudés, des bossages conducteurs peuvent être prévus sur les plots 28 pour un montage de type "flip-chip", comme on le verra plus loin.

Pour un capteur d'image radiologique, on dépose alors (si les fibres ne sont pas scintillatrices) une structure scintillatrice sur la face supérieure de la galette de fibres optiques. De préférence, la structure est constituée par une couche scintillatrice d'iodure de césium 32 déposée sur une feuille mince de carbone 34, l'ensemble constituant une feuille souple scintillatrice 30 qu'on colle, du côté de l'iodure de césium, sur la face accessible de la galette de fibres optiques 20 comme représenté à la figure 8.

A ce stade, la fabrication collective est terminée et la structure de galette portant les circuits intégrés formés dans la tranche semiconductrice 12 peut être divisée en puces individuelles correspondant chacune à un capteur d'image individuel. Ces puces sont montées sur un support auquel elles sont reliées électriquement. Ce support peut-être l'embase d'un boîtier où un circuit imprimé sur substrat de résine ou substrat céramique portant d'autres composants. La division en puces individuelles se fait en sciant la structure collective à partir d'une seule face de cette structure (de préférence du côté de la tranche). II n'est pas nécessaire de scier à la fois par le haut et par le bas selon des traits de scie différents.

La figure 9 représente une puce de capteur individuelle, fixée sur un support 40. La puce comprend une structure superposée d'un élément de galette de fibres 20 et d'un élément de feuille semiconductrice 12 (la galette portant un scintillateur 30 dans le cas d'un capteur d'image radiologique). Les bords périphériques de la galette découpée sont superposés en coïncidence exacte avec les bords périphériques de la feuille semiconductrice, du fait de la découpe de chaque côté de la puce par un trait de scie unique qui découpe à la fois la galette et la tranche amincie.

La puce est collée par sa face arrière (la face qui porte la feuille semiconductrice et sa couche conductrice 26) sur une première face du support 40. Elle déborde latéralement un peu du support et des fils de connexion 42 sont soudés entre les plots conducteurs tels que 28 et des plages conductrices 44 formées sur l'autre face du support 40.

Un montage de type "flip-chip" est également possible, c'est-à-dire que les plages 44 sont cette fois sur la première face du support et les plots 28, revêtus de bossages conducteurs, sont en regard des plages 44 et peuvent être soudés directement, plot à plot, sur ces plages. C'est particulièrement intéressant en termes d'encombrement et d'autoalignement ; on peut notamment réaliser des ensembles de prise d'image à plusieurs puces juxtaposées, de positions précisément indexées, dits "plans focaux", utilisés notamment en radiographie à balayage.

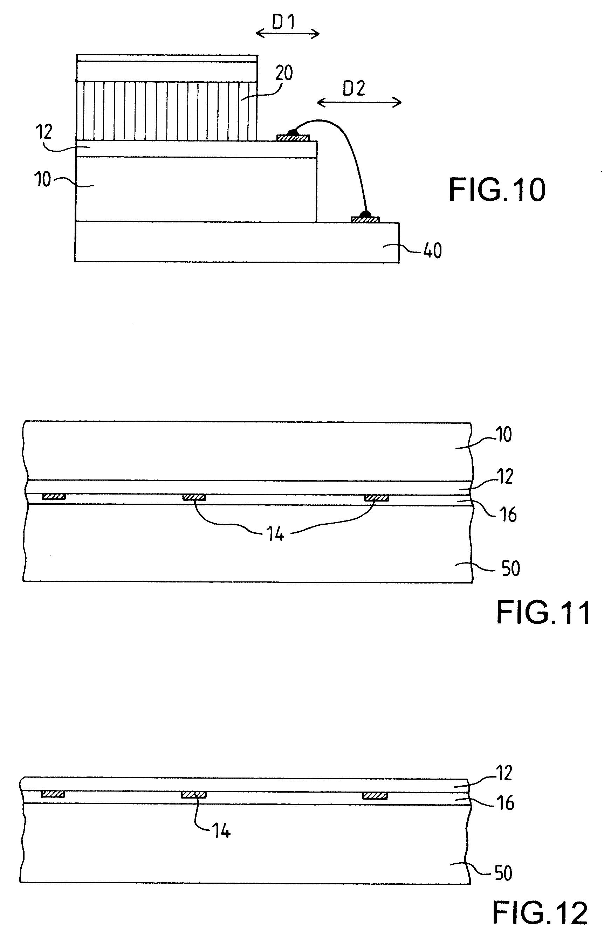

Dans les deux cas, l'encombrement latéral du capteur terminé est réduit par rapport à l'art antérieur (à surface d'image égale) ; dans l'art antérieur tel que représenté sur la figure 10, si on avait une galette de fibres montée sur une puce semiconductrice classique, il fallait prévoir un débordement latéral D1 de la puce par rapport à la galette (pour les plots de soudure sur la puce) et un débordement latéral D2 du support par rapport à la puce (pour les plages de soudure sur le support). Dans l'invention, non seulement il n'y a pas de débord de la feuille semiconductrice par rapport à la galette ou réciproquement, mais il n'y a pas de nécessité de débordement de la puce (feuille+galette) par rapport au support sur lequel la structure est montée et soudée. De plus, les marges liées aux tolérances de fabrication peuvent être plus faibles que dans les assemblages sur puces individuelles. Enfin, la diminution d'encombrement peut se faire aussi sur les bords de puces où il n'y a pas de plots , alors que dans l'art antérieur on faisait dépasser la galette de fibres sur ces bords, pour tenir compte de dépositionnements possibles de la galette.

Ainsi, dans le capteur selon l'invention la galette de fibres optiques 20 a un bord périphérique en coïncidence exacte avec le bord périphérique de la feuille semiconductrice 12 qui subsiste. La structure scintillatrice 30 a également un bord périphérique en coïncidence exacte avec le bord de la galette puisqu'elle a été mise en place au cours de la fabrication collective avant découpage.

Le capteur terminé, visible à la figure 9, est destiné à être illuminé par les rayons X en provenance du haut ; la matrice photosensible sur substrat semiconducteur aminci est éclairée par la lumière du scintillateur par le côté de sa face avant, contrairement à ce qui se passe normalement pour des capteurs d'image à substrat aminci.

Les figures 11 à 16 représentent un deuxième mode de réalisation du capteur selon l'invention. Dans ce deuxième mode, l'illumination de la matrice photosensible se fait par l'arrière de la tranche.

On part d'une tranche semiconductrice sur laquelle on exécute collectivement, comme cela a été expliqué en référence à la figure 1 toutes les opérations nécessaires à la réalisation des matrices photosensibles et de leurs circuits associés, y compris les interconnexions conductrices.

On notera cependant que, contrairement à la réalisation des figures 1 à 9, on prévoit des plages métalliques 14 qui serviront directement de plots de contact extérieur pour la connexion avec l'extérieur ; dans le premier mode de réalisation, comme on le voit à la figure 9, les plages 14 servent indirectement à la connexion extérieure puisque les plots de soudure sont les plages 28, reliées aux plages 14 par les vias 24.

Avec cette petite différence, on part de la tranche de la figure 2, planarisée par une couche d'oxyde de silicium 16 et polie, et on la reporte sur un substrat de report provisoire 50. Sur la figure 11, on a représenté la tranche semiconductrice retournée, avec sa face avant vers le bas, collée contre le substrat de report 50.

Le collage se fait là encore par adhérence moléculaire entre des surfaces très planes de la tranche planarisée et du substrat de report.

L'étape suivante (figure 12) consiste à amincir la tranche jusqu'à ne plus laisser subsister qu'une très faible épaisseur correspondant à une partie seulement de l'épaisseur de la couche épitaxiale 12, ou éventuellement à toute la couche épitaxiale et une très faible épaisseur du substrat semiconducteur d'origine 10. L'épaisseur finale de la tranche amincie est au plus de 30 micromètres et peut descendre même à quelques micromètres.

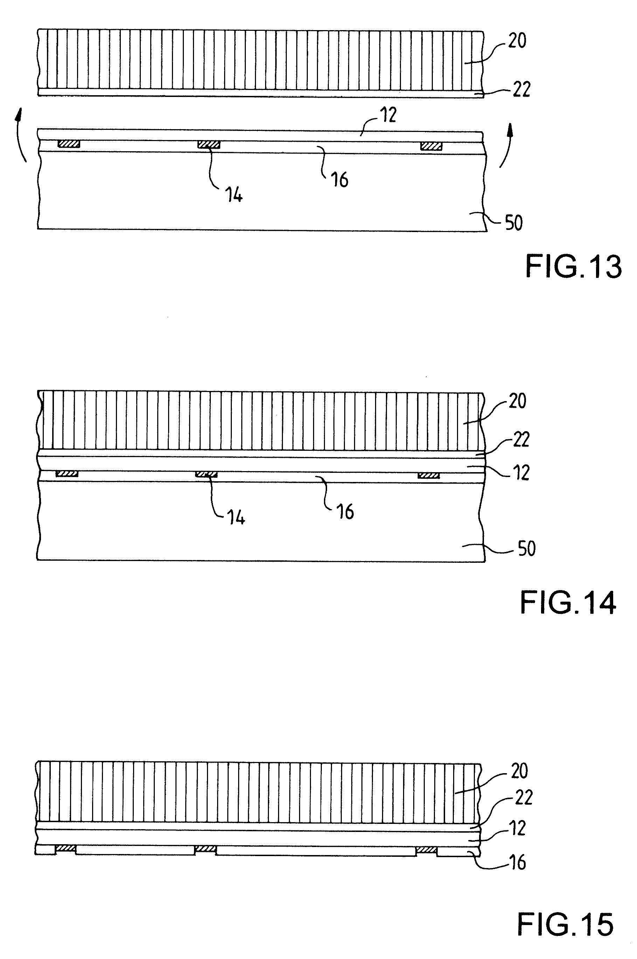

On va ensuite (figure 13) coller la structure ainsi amincie, par le côté de la face arrière amincie de la tranche, sur une galette de fibres optiques 20. Pour cela on peut éventuellement déposer une couche de planarisation (non représentée) sur cette face arrière pour faciliter le collage ultérieur par adhérence moléculaire.

La galette de fibres optiques est la même que celle de la figure 3, revêtue si nécessaire d'une couche de planarisation 22 permettant, après polissage jusqu'à une rugosité très faible, un collage par adhérence moléculaire.

La structure collective à ce stade est représentée à la figure 14, avec l'empilement suivant : un substrat de report provisoire 50, une tranche semiconductrice très amincie 12, et une galette de fibres optiques 20.

L'étape suivante consiste à éliminer le substrat de report provisoire 50. L'élimination peut se faire par usinage, mais comme le substrat 50 a été collé par adhérence moléculaire, il existe aussi des techniques spécifiques de décollage utilisant par exemple une implantation préalable superficielle d'hydrogène avant collage pour faciliter le décollage ultérieur.

Une fois que le décollage est effectué, on effectue une opération de mise à nu des plages conductrices 14 qui doivent servir de plots de soudure pour l'accès extérieur. Cette mise à nu se fait par photolithographie en ouvrant des ouvertures, en regard de ces plages, dans les couches qui la recouvrent, notamment la couche 16 (figure 15).

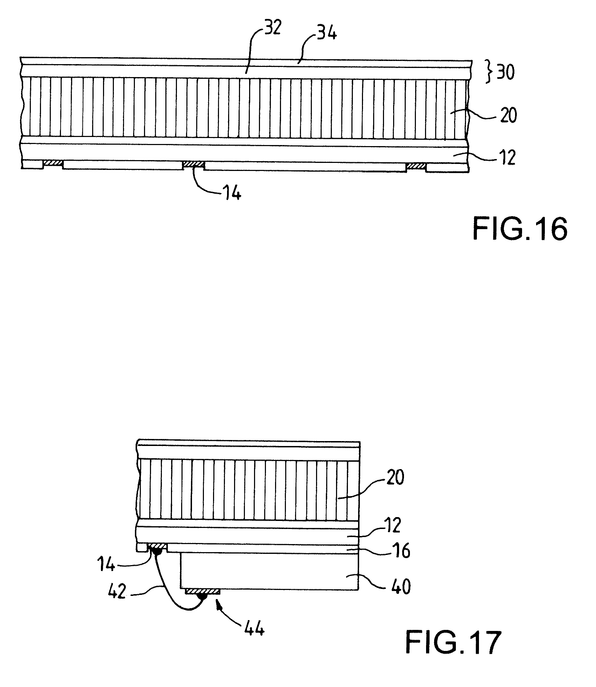

La fabrication collective comprend encore une mise en place d'une feuille scintillatrice sur la face accessible de la galette de fibres optiques (figure 16) dans le cas d'un capteur radiologique dans lequel les fibres de la galette ne seraient pas elles-mêmes scintillatrices. La feuille scintillatrice 30 est la même qu'à la figure 8. Elle est collée sur la structure collective comprenant la galette et la tranche, avant division en puces individuelles. Elle pourrait être collée avant la mise à nu des contacts, ou encore après la découpe en puces individuelles.

Les opérations de fabrication collectives sont maintenant terminées pour l'essentiel de ce qui concerne l'invention. Il reste à découper la structure superposée galette de fibres+tranche semiconductrice en puces constituant chacune un capteur d'image individuel. La découpe se fait à partir d'une seule face de l'ensemble galette+tranche. Les bords périphériques de la puce, de la galette, et du scintillateur, sont en coïncidence exacte.

Les puces individuelles sont montées chacune sur un support 40 (embase de boîtier ou circuit imprimé comportant d'autres composants) comme cela est représenté à la figure 17.

La puce est collée sur la première face du substrat. Des fils de connexion 42 sont soudés d'un côté sur les plots 14 dénudés et de l'autre sur la face opposée du support 40. La puce déborde légèrement, comme à la figure 9, par rapport au bord du support 40. Là encore, on gagne beaucoup en encombrement latéral par rapport à la disposition classique de la figure 10, car le bord de la tranche semiconductrice et le bord de la galette sont superposés et le support 40 n'est pas nécessairement en débord par rapport aux bords de tranche et de galette.

Le capteur là encore être monté sur le support 40 selon la technique flip-chip (soudure plot à plot).

Le capteur d'image est éclairé par le côté de la face arrière de la tranche semiconductrice amincie, ce qui est très avantageux (pour la sensibilité dans toute la gamme visible et notamment dans le bleu), et d'autre part l'accès aux plots de soudure est particulièrement simple puisqu'il n'implique pas de vias à travers l'épaisseur de la tranche amincie (sauf si des vias sont utiles pour d'autres raisons). Mais cette réalisation nécessite un double report de la tranche, d'abord sur un substrat provisoire puis sur la galette de fibres optiques.

## Revendications

1. Procédé de fabrication d'un capteur d'image radiologique intraoral dentaire comprenant des étapes de réalisation collective d'une structure associant une tranche semiconductrice (10, 12) portant un réseau matriciel de détecteurs photosensibles intégrés dans la tranche, et une galette de fibres optiques (20) fixée par adhérence moléculaire sans apport de matière adhésive , la tranche semiconductrice étant amincie dans une étape postérieure à la formation des circuits de détection d'image sur la tranche et on réalise, sur la face de la tranche non fixée à la galette de fibres, des plots de contact d'accès extérieur (17,28) pour la commande des circuits et le recueil de signaux d'image issus du capteur, la galette de fibres optiques ayant une épaisseur telle qu'elle assure l'essentiel de la tenue mécanique de la structure une fois que la tranche a été amincie, et ceci jusqu'à la fin de la fabrication collective, la structure assemblée de la tranche et de la galette étant ultérieurement découpée en puces individuelles.

2. Procédé selon la revendication 1, **caractérisé en ce que** l'on découpe la galette et la tranche semiconductrice selon une même ligne de découpe pour définir les puces individuelles.

3. Procédé selon l'une des revendications 1 à 2, **caractérisé en ce qu'**il comporte les étapes suivantes :
- on réalise à partir d'une face avant de la tranche semiconductrice, par des étapes de dépôt et gravures de couches successives, un ensemble de matrices de zones photosensibles et de circuits électroniques associés,
- on planarise la face avant de la tranche, on planarise également une face avant d'une galette de fibres optiques (20) d'épaisseur suffisante pour assurer la tenue mécanique de la tranche pendant le reste de la fabrication de celle-ci avant découpage en puces individuelles,
- on colle la galette par sa face avant planarisée contre la face avant planarisée de la tranche, le collage étant effectué par adhérence moléculaire sans interposition de matière adhésive,
- on élimine la majeure partie de l'épaisseur de la tranche semiconductrice (10, 12) par usinage de la face arrière de celle-ci,
- on ouvre localement des vias (24) dans la face arrière de la tranche amincie (12), sur toute l'épaisseur de celle-ci, pour mettre à nu des plages conductrices (14) préalablement formées sur la face avant,
- on forme, sur la face arrière, des plots de contact extérieur (28) reliés à ces zones conductrices à travers les vias,
- et, ultérieurement, on découpe la tranche en puces individuelles.

4. Procédé selon la revendication 3, **caractérisé en ce qu'**on fixe la face arrière de la tranche semiconductrice de la puce découpée sur une face avant d'un support (40) comportant des plages conductrices (44) sur sa face arrière, les plots (28) étant reliés aux plages conductrices (44) par des fils soudés.

5. Procédé selon la revendication 4, **caractérisé en ce qu'**on fixe la face arrière de la puce découpée sur une face avant d'un support (40) comportant des plages conductrices, les plots de la tranche étant en regard des plages du support et étant pourvus de bossages conducteurs soudés directement aux plages du support.

6. Procédé selon l'une des revendications 1 et 2, **caractérisé en ce qu'**il comporte les étapes suivantes :
- on réalise à partir d'une face avant de la tranche semiconductrice (10, 12), par des étapes de dépôt et gravures de couches successives, un ensemble de matrices de zones photosensibles et de circuits électroniques associés, et des plages de contact d'accès extérieur (14) permettant la commande du capteur et le recueil de signaux d'image,
- on colle la face avant de la tranche contre la face avant d'un substrat de report provisoire (50), on élimine la majeure partie de l'épaisseur de la tranche par usinage de la face arrière de celle-ci,
- on planarise la face arrière de la tranche amincie (12), on planarise une face avant d'une galette de fibres optiques (20) d'épaisseur suffisante pour assurer la tenue mécanique de la tranche pendant le reste de la fabrication de celle-ci avant découpage en capteurs d'image individuels, on colle la galette par sa face avant planarisée contre la face arrière planarisée de la tranche, le collage étant effectué par adhérence moléculaire sans apport de matière adhésive,
- on élimine le substrat de report provisoire (50), on dénude les plages de contact d'accès extérieur (14),
- et, ultérieurement, on découpe la tranche en puces individuelles.

7. Procédé selon la revendication 6, **caractérisé en ce qu'**on fixe la face avant de la tranche semiconductrice de la puce découpée sur une face avant d'un support (40) comportant des plages conductrices (44) sur sa face arrière, et on soude des fils de connexion entre les plages (14) de la tranche et les plages (44) du support.

8. Procédé selon la revendication 6, **caractérisé en ce qu'**on fixe la face avant de la puce découpée sur une face avant d'un support (40) comportant des plages conductrices, les plages (14) de la tranche étant en regard des plages (44) du support et étant pourvues de bossages conducteurs soudés directement aux plages du support.

9. Procédé selon l'une des revendications 1 à 8, **caractérisé en ce que**, au cours des étapes de fabrication collective avant découpe en puces, on recouvre la galette de fibres optiques d'une structure de scintillateur (30).

10. Capteur d'image radiologique intraoral dentaire, comportant une puce formée d'une superposition d'une galette de fibres optiques (20) et d'une feuille semiconductrice (12), d'épaisseur plus faible que l'épaisseur de la galette et inférieure à 30 micromètres, feuille dans laquelle sont formés une matrice de zones photosensibles et des circuits électroniques associés, la feuille étant collée à la galette par adhérence moléculaire sans apport de matière adhésive, la feuille comportant sur sa face non collée à la galette de fibres des plots de contact d'accès extérieur (14,28) permettant la commande du capteur et le recueil de signaux d'image issus de la matrice.

11. Capteur d'image selon la revendication 10, **caractérisé en ce que** la face de la feuille semiconductrice (12) collée à la galette de fibres (20) est une face avant de la feuille, face sur laquelle sont formés la matrice photosensible et les circuits électroniques, **en ce que** les plots de contact (28, fig. 9) sont reliés aux circuits électroniques de la face avant à travers des vias (24) ouverts de la face arrière à la face avant de la feuille.

12. Capteur d'image selon la revendication 11, **caractérisé en ce que** la face de la feuille semiconductrice collée à la galette est une face arrière de la feuille, la matrice photosensible, les circuits électroniques, et les plots de contact étant formés sur la face avant de la feuille.

13. Capteur d'image selon l'une des revendications 10 à 12, **caractérisé en ce que** le bord périphérique de la galette et le bord périphérique de la feuille semiconductrice sont superposés en coïncidence exacte.

14. Capteur d'image selon l'une des revendications 10 à 13, caracatérisé en ce que la puce constituée par la feuille et la galette superposées est fixée sur une face avant d'un support, des fils de connexion étant soudés entre les plots de contact et une face arrière du support.

15. Capteur d'image selon l'une des revendications 10 à 13, **caractérisé en ce que** la puce constituée par la feuille et la galette superposées est fixée sur une face avant d'un support, les plots de contact de la feuille étant soudées directement sur des plages conductrices de la face avant du support, les plages du support étant en regard des plots de contact de la feuille.

16. Capteur d'image selon l'une des revendications 10 à 15, **caractérisé en ce qu'**il comporte, sur une face de galette non collée à la feuille semiconductrice, une structure scintillatrice.

17. Capteur d'image selon la revendication 16, **caractérisé en ce que** le bord périphérique de la structure scintillatrice est superposé en coïncidence exacte avec le bord de la galette.

## Patentansprüche

1. Verfahren zur Herstellung eines zahnmedizinischen, intraoralen radiologischen Bildsensors, das die folgenden Schritte beinhaltet: kollektives Realisieren einer Struktur, die einen Halbleiterwafer (10, 12), der eine Matrix von in den Wafer integrierten fotoempfindlichen Detektoren trägt, und eine Glasfasergalette (20) umfasst, die durch molekulare Haftung ohne Zufuhr von Klebstoffmaterial befestigt ist, wobei der Halbleiterwafer in einem Schritt nach der Bildung von Bilderkennungsschaltungen auf dem Wafer verdünnt wird und auf der nicht an der Fasergalette befestigten Fläche des Wafers Kontaktstellen (17, 28) für externen Zugriff zum Steuern der Schaltungen und zum Erfassen von von dem Sensor ausgegebenen Bildsignalen realisiert werden, wobei die Glasfasergalette eine solche Dicke hat, dass sie im Wesentlichen das mechanische Halten der Struktur nach dem Verdünnen des Wafers gewährleistet, und dies bis zum Ende der kollektiven Herstellung, wobei die zusammengefügte Struktur des Wafers und der Galette schließlich zu einzelnen Chips geschnitten wird.

2. Verfahren nach Anspruch 1, **dadurch gekennzeichnet, dass** die Galette und der Halbleiterwafer entlang einer selben Schnittlinie geschnitten werden, um die einzelnen Chips zu definieren.

3. Verfahren nach einem der Ansprüche 1 bis 2, **dadurch gekennzeichnet, dass** es die folgenden Schritte beinhaltet:
- Realisieren, von einer Vorderseite des Halbleiterwafers, durch Schritte des Absetzens und Ätzens von aufeinanderfolgenden Schichten, eines Satzes von Matrizen von fotoempfindlichen Zonen und assoziierten elektronischen Schaltungen,
- Planarisieren der Vorderseite des Wafers, ebenfalls Planarisieren einer Vorderseite einer Glasfasergalette (20) mit einer Dicke, die ausreicht, um das mechanische Halten des Wafers beim Rest der Herstellung derselben vor dem Schneiden in einzelne Chips zu gewährleisten,
- Kleben der Galette mit ihrer planarisierten Vorderseite auf die planarisierte Vorderseite des Wafers, wobei das Kleben durch molekulare Haftung ohne Interposition von Klebstoff erfolgt,
- Entfernen des größten Teils der Dicke des Halbleiterwafers (10, 12) durch Bearbeiten der Rückseite desselben,
- lokales Einarbeiten von Durchkontaktierungen (24) in die Rückseite des verdünnten Wafers (12) über die gesamte Dicke desselben, um die zuvor auf der Vorderseite gebildeten leitenden Bereiche (14) freizulegen,
- Bilden, auf der Rückseite, von mit diesen leitenden Zonen verbundenen äußeren Kontaktstellen (28) durch die Durchkontaktierungen,
- und schließlich Schneiden des Wafers in einzelne Chips.

4. Verfahren nach Anspruch 3, **dadurch gekennzeichnet, dass** die Rückseite des Halbleiterwafers des geschnittenen Chips auf einer Vorderseite eines Trägers (40) befestigt wird, der leitende Bereiche (44) auf der Rückseite aufweist, wobei die Kontaktstellen (28) durch gelötete Drähte mit den leitenden Bereichen (44) verbunden sind.

5. Verfahren nach Anspruch 4, **dadurch gekennzeichnet, dass** die Rückseite des geschnittenen Chips auf einer Vorderseite eines Trägers (40) befestigt wird, der leitende Bereiche umfasst, wobei die Kontaktstellen des Wafers gegenüber den Bereichen des Trägers liegen und mit Leitungshügeln versehen sind, die direkt auf die Bereiche des Trägers gelötet sind.

6. Verfahren nach einem der Ansprüche 1 und 2, **dadurch gekennzeichnet, dass** es die folgenden Schritte beinhaltet:
- Realisieren, von einer Vorderseite des Halbleiterwafers (10, 12), durch die Schritte des Absetzens und Ätzens von aufeinanderfolgenden Schichten, eines Satzes von Matrizen von fotoempfindlichen Zonen und von assoziierten elektronischen Schaltungen und von Kontaktbereichen (14) mit externem Zugriff, die das Steuern des Sensors und das Erfassen von Bildsignalen zulassen,
- Kleben der Vorderseite des Wafers auf die Vorderseite eines provisorischen Umdrucksubstrats (50), Entfernen des größten Teils der Dicke des Wafers durch Bearbeiten der Rückseite desselben,
- Planarisieren der Rückseite des verdünnten Wafers (12), Planarisieren einer Vorderseite einer Glasfasergalette (20) mit einer Dicke, die ausreicht, um das mechanische Halten des Wafers für den Rest der Herstellung desselben vor dem Schneiden in einzelne Bildsensoren zu gewährleisten, Kleben der Galette mit der planarisierten Vorderseite auf die planarisiere Rückseite des Wafers, wobei das Kleben durch molekulare Haftung ohne Auftrag von Klebstoff erfolgt,
- Entfernen des provisorischen Umdrucksubstrats (50), Freilegen der Kontaktbereiche (14) mit externem Zugriff,
- und schließlich Schneiden des Wafers in einzelne Chips.

7. Verfahren nach Anspruch 6, **dadurch gekennzeichnet, dass** die Vorderseite des Halbleiterwafers des geschnittenen Chips an einer Vorderseite eines Trägers (40) befestigt wird, der leitende Bereiche (44) auf der Rückseite aufweist, und Löten der Verbindungsdrähte zwischen den Bereichen (14) des Wafers und den Bereichen (44) des Trägers.

8. Verfahren nach Anspruch 6, **dadurch gekennzeichnet, dass** die Vorderseite des geschnittenen Chips an einer Vorderseite eines Trägers (40) befestigt wird, der leitende Bereiche umfasst, wobei die Bereiche (14) des Wafers gegenüber den Bereichen (44) des Trägers liegen und mit Leitungshügeln versehen sind, die direkt auf die Bereiche des Trägers gelötet sind.

9. Verfahren nach einem der Ansprüche 1 bis 8, **dadurch gekennzeichnet, dass** im Laufe der kollektiven Herstellungsschritte vor dem Schneiden in Chips die Glasfasergalette mit einer Szintillatorstruktur (30) bedeckt wird.

10. Zahnmedizinischer, intraoraler radiologischer Bildsensor, der einen Chip umfasst, der durch Übereinanderlegen einer Glasfasergalette (20) und einer Halbleiterfolie (12) mit einer Dicke gebildet ist, die geringer als die Dicke der Galette und weniger als 30 Millimeter ist, wobei in der Folie eine Matrix von fotoempfindlichen Zonen und von assoziierten elektronischen Schaltungen ausgebildet sind, wobei die Folie durch molekulare Haftung ohne Auftrag von Klebstoff auf die Galette geklebt wird, wobei die Folie auf ihrer nicht auf die Fasergalette geklebten Seite Kontaktstellen (14, 28) mit externem Zugriff umfasst, die die Steuerung des Sensors und das Erfassen von von der Matrix kommenden Bildsensoren zulässt.

11. Bildsensor nach Anspruch 10, **dadurch gekennzeichnet, dass** die auf die Fasergalette (20) geklebte Seite der Halbleiterfolie (12) eine Vorderseite der Folie ist, auf der die fotoempfindliche Matrix und die elektronischen Schaltungen ausgebildet sind, und dadurch, dass die Kontaktstellen (28, Fig. 9) mit den elektronischen Schaltungen der Vorderseite durch Durchkontaktierungen (24) verbunden sind, die von der Rückseite zur Vorderseite der Folie offen sind.

12. Bildsensor nach Anspruch 11, **dadurch gekennzeichnet, dass** die auf die Galette geklebte Seite der Halbleiterfolie eine Rückseite der Folie ist, wobei die photoempfindliche Matrix, die elektronischen Schaltungen und die Kontaktstellen auf der Vorderseite der Folie ausgebildet sind.

13. Bildsensor nach einem der Ansprüche 10 bis 12, **dadurch gekennzeichnet, dass** der periphere Rand der Galette und der periphere Rand der Halbleiterfolie in genauer Übereinstimmung aufeinander gelegt sind.

14. Bildsensor nach einem der Ansprüche 10 bis 13, **dadurch gekennzeichnet, dass** der durch die übereinander gelegte Folie und Galette gebildete Chip an einer Vorderseite eines Trägers befestigt ist, wobei die Verbindungsdrähte zwischen den Kontaktstellen und einer Rückseite des Trägers gelötet sind.

15. Bildsensor nach einem der Ansprüche 10 bis 13, **dadurch gekennzeichnet, dass** der durch die aufeinander gelegte Folie und Galette gebildete Chip an einer Vorderseite eines Trägers befestigt ist, wobei die Kontaktstellen der Folie direkt auf die leitenden Bereiche der Vorderseite des Trägers gelötet sind, wobei die Bereiche des Trägers den Kontaktstellen der Folie gegenüberliegen.

16. Bildsensor nach einem der Ansprüche 10 bis 15, **dadurch gekennzeichnet, dass** er auf einer nicht auf die Halbleiterfolie geklebten Galettenseite eine Szintillationsstruktur umfasst.

17. Bildsensor nach Anspruch 16, **dadurch gekennzeichnet, dass** der periphere Rand der Szintillationsstruktur in genauer Übereinstimmung mit dem Rand der Galette übereinander gelegt ist.

## Claims

1. A method of fabricating a dental intraoral radiological image sensor, comprising steps for the collective production of a structure combining a semiconductor wafer (10, 12), bearing a matrix of photosensitive detectors integrated into the wafer, and a fiber-optic plate (20) fixed by wafer bonding (i.e. molecular adhesion with no adhesive applied), the semiconductor wafer being thinned in a step subsequent to the formation of the image detection circuits on the wafer, and external access contact pads ( 17, 28) are produced on that face of the wafer which is not fixed to the fiber plate, said contact pads being for controlling the circuits and for receiving image signals coming from the sensor, the fiber-optic plate having a thickness such that it provides most of the mechanical integrity of the structure once the wafer has been thinned, and does so right to the end of the collective fabrication, the assembled structure consisting of the wafer and the plate being subsequently diced into individual chips.

2. The method as claimed in claim 1, **characterized in that** the plate and the semiconductor wafer are diced along one and the same dicing line to define the individual chips.

3. The method as claimed in either of claims 1 and 2, **characterized in that** it comprises the following steps:
- a number of matrices of photosensitive zones and of associated electronic circuits are produced from a front face of the semiconductor wafer by successive layer deposition and etching steps;
- the front face of the wafer is planarized, as is also a front face of a fiber-optic plate (20) of sufficient thickness to ensure mechanical integrity of the wafer during the rest of the fabrication thereof, before being diced into individual chips;
- the plate is bonded via its planarized front face to the planarized front face of the wafer, the bonding being carried out by wafer bonding without interposition of an adhesive;
- most of the thickness of the semiconductor wafer (10, 12) is removed by machining the rear face thereof;
- vias (24) are opened locally in the rear face of the thinned wafer (12), over the entire thickness of the latter, in order to bare conducting areas (14) preformed on the front face;
- external contact pads (28), which are connected to these conducting zones through the vias, are formed on the rear face; and
- subsequently, the wafer is diced into individual chips.

4. The method as claimed in claim 3, **characterized in that** the rear face of the semiconductor wafer of the diced chip is fixed to a front face of a support (40) that has conducting areas (44) on its rear face, the pads (28) being connected to the conducting areas (44) by wire-bonded wires.

5. The method as claimed in claim 4, **characterized in that** the rear face of the diced chip is fixed to a front face of a support (40) having conducting areas, the pads of the wafer facing the conducting areas of the support and being provided with conducting bumps soldered directly to the conducting areas of the support.

6. The method as claimed in either of claims 1 and 2, **characterized in that** it comprises the following steps:
- a number of matrices of photosensitive zones and of associated electronic circuits are produced from a front face of the semiconductor wafer (10, 12) by successive layer deposition and etching steps, and also produced are external access contact areas (14) allowing the sensor to be controlled and image signals to be received;
- the front face of the wafer is bonded to the front face of a temporary mounting substrate (50), and most of the thickness of the wafer is removed by machining the rear face of the latter;
- the rear face of the thinned wafer (12) is planarized, as is a front face of a fiber-optic plate (20) of sufficient thickness to provide the wafer with mechanical integrity during the rest of its fabrication before being diced into individual image sensors, and the plate is bonded by its planarized front face to the planarized rear face of the wafer, the bonding being carried out by wafer bonding with no adhesive applied;
- the temporary mounting substrate (50) is removed and the external access contact areas (14) are bared; and
- subsequently, the wafer is diced into individual chips.

7. The method as claimed in claim 6, **characterized in that** the front face of the semiconductor wafer of the diced chip is fixed to a front face of a support (40) that includes conducting areas (44) on its rear face, and connection wires are wire-bonded between the contact areas (14) of the wafer and the conducting areas (44) of the support.

8. The method as claimed in claim 6, **characterized in that** the front face of the diced chip is fixed to a front face of a support (40) that includes conducting areas, the contact areas (14) on the wafer facing the conducting areas (44) of the support and being provided with conducting bumps soldered directly to the conducting areas of the support.

9. The method as claimed in one of claims 1 to 8, **characterized in that**, during the collective fabrication steps before dicing into chips, the fiber-optic plate is covered with a scintillator structure (30).

10. A dental intraoral radiological image sensor, comprising a chip formed from a superposition of a fiber-optic plate (20) and a semiconductor wafer (12), having a thickness smaller than the thickness of the plate and being less than 30 microns, in which wafer a matrix of photosensitive zones and associated electronic circuits are formed, the wafer being bonded to the plate by wafer bonding without adhesive being applied, the wafer having, on its face not bonded to the fiber plate, external access contact pads (14, 28) for controlling the sensor and for receiving image signals coming from the matrix.

11. The image sensor as claimed in claim 10, **characterized in that** that face of the semiconductor wafer (12) which is bonded to the fiber plate (20) is a front face of the wafer, on which face the photosensitive matrix and the electronic circuits are formed, and **in that** the contact pads (28, figure 9) are connected to the electronic circuits on the front face through vias (24) open from the rear face to the front face of the wafer.

12. The image sensor as claimed in claim 11, **characterized in that** that face of the semiconductor wafer which is bonded to the plate is a rear face of the wafer, the photosensitive matrix, the electronic circuits and the contact pads all being formed on the front face of the wafer.

13. The image sensor as claimed in one of claims 10 to 12, **characterized in that** the peripheral edge of the plate and the peripheral edge of the semiconductor wafer are superposed so as to coincide exactly.

14. The image sensor as claimed in one of claims 10 to 13, **characterized in that** the chip consisting of the superposed wafer and plate is fixed to a front face of a support, connection wires being wire-bonded between the contact pads and a rear face of the support.

15. The image sensor as claimed in one of claims 10 to 13, **characterized in that** the chip consisting of the superposed wafer and plate is fixed to a front face of a support, the contact pads of the wafer being bonded directly to conducting areas of the front face of the support, the conducting areas of the support facing the contact pads of the wafer.

16. The image sensor as claimed in one of claims 10 to 15, **characterized in that** it includes a scintillating structure on a plate face not bonded to the semiconductor wafer.

17. The image sensor as claimed in claim 16, **characterized in that** the peripheral edge of the scintillating structure is superposed so as to coincide exactly with the edge of the wafer.
